(19) Europäisches Patentamt
European Patent Office
Office européen des brevets

(11) EP 3 817 515 A1

(12) DEMANDE DE BREVET EUROPEEN

(43) Date de publication:
05.05.2021 Bulletin 2021/18

(51) Int Cl.:
H05F 3/02 (2006.01)　　H05F 3/04 (2006.01)
G01R 31/52 (2020.01)　　G01R 27/02 (2006.01)
G01R 31/28 (2006.01)　　G01R 31/54 (2020.01)

(21) Numéro de dépôt: 20204992.0

(22) Date de dépôt: 30.10.2020

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
Etats de validation désignés:
KH MA MD TN

(30) Priorité: 31.10.2019 FR 1912266

(71) Demandeur: Lacroix Electronics
49110 Montrevault sur Evre (FR)

(72) Inventeurs:
• ABBASSI, Walid
7130 El KEF (TN)
• HELIES, Jean-Baptiste
35000 RENNES (FR)

(74) Mandataire: Lavoix
2, place d'Estienne d'Orves
75441 Paris Cedex 09 (FR)

(54) **SYSTÈME DE PROTECTION CONTRE DES DÉCHARGES ÉLECTROSTATIQUES**

(57) L'invention concerne un système de protection de protection contre des décharges électrostatiques, comportant un dispositif de protection (30) adapté à être connecté à un dispositif de contact (20) antistatique assurant une protection contre des décharges électrostatiques lorsqu'il est porté par un opérateur (6) d'un poste de travail (4) comportant une pluralité d'équipements (8, 10) adaptés à fonctionner lorsqu'ils sont alimentés en électricité. Ce dispositif de protection (30) est connecté entre le dispositif de contact (20) et un module de connexion électrique (16) du poste de travail, et il est configuré pour vérifier la présence d'un contact entre dispositif de contact (20) assurant une protection contre les décharges électrostatiques et la peau d'un opérateur (6). En cas vérification positive, le dispositif de protection (30) commande le module de connexion électrique (16) pour fournir une alimentation électrique à tous les équipements du poste de travail, et en cas de vérification négative, le dispositif de protection (30) commande une coupure de l'alimentation électrique des équipements du poste de travail.

FIG.1

**Description**

La présente invention concerne un système de protection contre des décharges électrostatiques, susceptibles de détériorer un produit électronique en cours de fabrication.

L'invention se situe dans le domaine de la protection contre des décharges électrostatiques, à la fois la protection des opérateurs humains, travaillant sur des postes de travail comportant des équipements à alimentation électrique et la protection contre l'endommagement des produits fabriqués.

En particulier, l'invention trouve une application dans le domaine de la fabrication des composants électroniques (e.g. des circuits imprimés), qui risquent d'être endommagés par d'éventuelles décharges électrostatiques.

Ce problème est connu dans l'état de la technique. Pour y répondre, il a été prévu d'équiper les opérateurs de postes de travail en usine de fabrication de composants électroniques de divers dispositifs à porter : bracelet, ou autre dispositif porté en contact avec la peau, de protection contre les décharges électrostatiques, également appelé bracelet anti-ESD (pour « electrostatic discharge »), porté au poignet par l'opérateur, chaussures antistatiques, tapis de sol antistatique. De plus, les postes de travail sont équipés de systèmes de connexion à la terre (potentiel 0 volts) pour éliminer d'éventuelles décharges électrostatiques.

Ces dispositifs de protection ont pour objet d'éviter tout endommagement des composants électroniques fabriqués, et de protéger l'opérateur également.

Divers systèmes de détection de dysfonctionnement des dispositifs antistatiques ont été mis au point, de manière à détecter d'éventuelles ruptures de câbles de connexion pouvant conduire à une protection inefficace, du poste de travail ou de l'opérateur, en cas de décharge électrostatique.

L'invention a pour objectif d'améliorer encore la sécurité des systèmes de protection contre les décharges électrostatiques pour des postes de travail, permettant ainsi d'améliorer à la fois la sécurité de l'opérateur du poste de travail et d'éviter l'endommagement de composants électroniques fabriqués à ce poste de travail.

A cet effet, l'invention propose un système de protection contre des décharges électrostatiques comportant un dispositif de protection adapté à être connecté à un dispositif de contact antistatique assurant une protection contre des décharges électrostatiques lorsqu'il est porté par un opérateur d'un poste de travail comportant une pluralité d'équipements adaptés à fonctionner lorsqu'ils sont alimentés en électricité. Dans ce système, ledit dispositif de protection est connecté entre le dispositif de contact antistatique et un module de connexion électrique du poste de travail. Le dispositif de protection est configuré pour vérifier la présence d'un contact entre dispositif de contact antistatique assurant une protection contre les décharges électrostatiques et la peau d'un opérateur, et en cas vérification positive, le dispositif de protection commande le module de connexion électrique pour fournir une alimentation électrique à tous les équipements du poste de travail, et en cas de vérification négative, le dispositif de protection commande une coupure de l'alimentation électrique des équipements du poste de travail.

Avantageusement, grâce à l'utilisation du dispositif de protection revendiqué et au conditionnement de la mise sous tension de l'ensemble des équipements d'un poste de travail à la vérification positive du port d'un dispositif de contact antistatique avec la peau, assurant une protection contre les charges électrostatiques, par un opérateur, tout risque d'accumulation de charges électrostatiques est éliminé.

Le système de protection contre des décharges électrostatiques selon l'invention peut présenter une ou plusieurs des caractéristiques ci-dessous, prises indépendamment ou selon toutes les combinaisons acceptables.

Pour la vérification de présence d'un contact entre ledit dispositif de contact antistatique et la peau d'un opérateur, le dispositif de protection met en oeuvre une vérification de résistance et une vérification de capacité.

Le dispositif de protection comprend un circuit de vérification de présence d'un contact, comportant un comparateur, une sortie du dispositif de contact antistatique étant connectée à une entrée dudit comparateur.

Ledit circuit de vérification de présence d'un contact comprend une source de tension alimentant, avec une tension inférieure ou égale à 10 Volts, le dispositif de contact antistatique.

Le dispositif de protection comporte en outre un module de calcul électronique configuré pour calculer une valeur de résistance estimée et une valeur de capacité estimée.

Le module de calcul électronique est configuré pour vérifier, lors d'une première vérification, si la valeur de résistance estimée appartient à une plage de valeurs de résistance prédéterminée, et pour vérifier, lors d'une deuxième vérification, si la valeur de capacité estimée appartient à une plage de valeurs de capacité prédéterminée.

Ladite plage de valeurs de résistance est définie par un première valeur de résistance minimale et une deuxième valeur de résistance maximale, préalablement calculées dans une phase de calibrage et enregistrées. Lesdites première valeur de résistance minimale et une deuxième valeur de résistance maximale sont par exemple des valeurs moyennes obtenues pour des opérateurs humains.

Ladite plage de valeurs de capacité est définie par un première valeur de capacité minimale et une deuxième valeur de capacité maximale, préalablement calculées dans une phase de calibrage et enregistrées. Lesdites première valeur de capacité minimale et une deuxième valeur de capacité maximale sont par exemple des valeurs moyennes obtenues pour des opérateurs humains.

La vérification de présence d'un contact entre le dispositif de contact antistatique assurant une protection contre les décharges électrostatiques et la peau d'un opérateur est positive si ladite première vérification est positive et ladite deuxième vérification est positive.

La vérification de présence d'un contact entre le dispositif de contact antistatique assurant une protection contre les décharges électrostatiques et la peau d'un opérateur est négative si l'une au moins desdites première vérification et deuxième vérification est négative.

Selon un autre aspect, l'invention concerne un procédé de protection contre des décharges électrostatiques, mis en oeuvre par un module de calcul électronique d'un dispositif de protection faisant partie d'un système de protection tel que brièvement décrit ci-dessus. Ce procédé comprend des étapes de :

- vérification de présence d'un contact entre le dispositif de contact antistatique assurant une protection contre les décharges électrostatiques et la peau d'un opérateur,

et en cas vérification positive, commande de fourniture d'alimentation électrique à tous les équipements du poste de travail, et en cas de vérification négative, commande de coupure de l'alimentation électrique des équipements du poste de travail.

Les avantages du procédé de protection contre des décharges électrostatiques sont analogues aux avantages du dispositif de protection contre des décharges électrostatiques brièvement décrit ci-dessus.

Selon une caractéristique, la vérification de présence d'un contact comporte :

- une estimation de valeur de résistance et de valeur de capacité à partir de valeurs de tension mesurées sur des intervalles de mesure,
- une première vérification consistant à vérifier si la valeur de résistance estimée appartient à une plage de valeurs de résistance prédéterminée, et
- une deuxième vérification consistant à vérifier si la valeur de capacité estimée appartient à une plage de valeurs de capacité prédéterminée, ladite vérification de présence étant positive si la première vérification et la deuxième vérification sont positives.

Selon une caractéristique, le procédé comporte en outre une mémorisation des valeurs de résistance et de capacité estimées et du résultat de la vérification de présence associé.

D'autres caractéristiques et avantages de l'invention ressortiront de la description qui en est donnée ci-dessous, à titre indicatif et nullement limitatif, en référence aux figures annexées, parmi lesquelles :

[Fig 1] la figure 1 illustre schématiquement un système de protection contre des décharges électrostatiques selon l'invention dans un scénario d'utilisation ;

[Fig 2] la figure 2 est un synoptique d'un mode de réalisation d'un dispositif de protection contre des décharges électrostatiques selon l'invention ;

[Fig 3] la figure 3 est un graphe illustrant schématiquement l'évolution de la tension mesurée dans un dispositif de protection selon un mode de réalisation ;

[Fig 4] la figure 4 est un synoptique des principales étapes d'un procédé de protection contre des décharges électrostatiques selon un mode de réalisation.

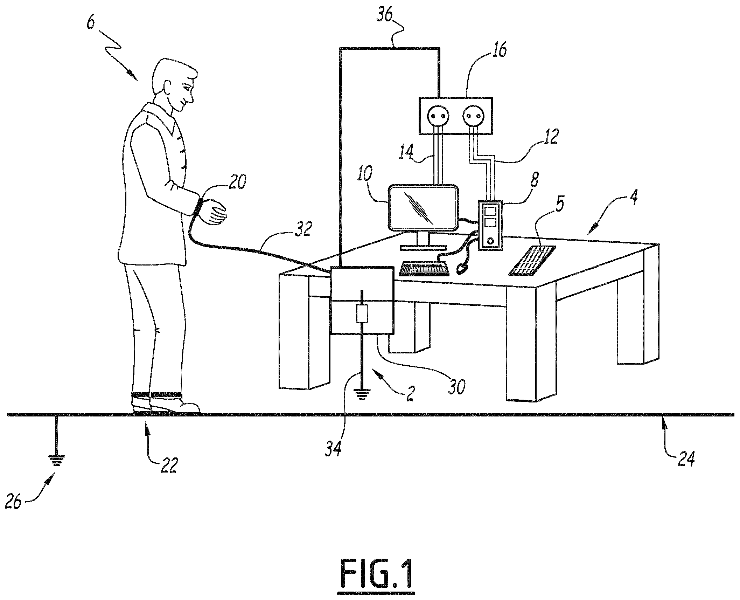

La figure 1 illustre schématiquement un système de protection 2 contre des décharges électrostatiques pour un poste de travail 4, opéré par un opérateur 6.

Par exemple, le poste de travail 4 est un poste de travail dans une usine de fabrication de composants électroniques 5, qui sont par exemple des cartes électroniques à circuits imprimés.

Le poste de travail 4 comporte plusieurs équipements 8, 10 adaptés à fonctionner lorsqu'ils sont alimentés par une alimentation électrique via des câbles de 12, 14 d'alimentation électrique. Les équipement 8, 10 sont par exemple un ordinateur, un écran d'ordinateur, ou tout autre équipement de travail.

Dans l'exemple de la figure 1, les câbles d'alimentation électrique sont connectés à un module de connexion électrique 16, dont des prises de courant sont illustrées sur la figure 1. Le module de connexion 16 est adapté à commander l'alimentation électrique des équipements du poste de travail par un réseau d'alimentation électrique non représenté.

L'opérateur 6 est équipé de dispositifs de protection contre les décharges électrostatiques ou dispositifs antistatiques qui sont respectivement un bracelet antistatique 20, dit bracelet de protection ci-après, et des chaussures antistatiques 22, destinées à rester en contact via une impédance de l'ordre de 1 à 2 MOhms avec un tapis 24 relié à la terre, c'est-à-dire à un potentiel de 0 Volt, ce qui est illustré par le symbole 26.

Dans l'exemple de la figure 1 l'opérateur est équipé d'un bracelet de protection antistatique, mais tout autre dispositif de contact antistatique, adapté à être porté en contact avec la peau par un opérateur pour assurer une protection contre des décharges électrostatiques, est utilisable. Donc plus généralement, le système de protection contre des décharges électrostatique 20 comporte un dispositif de contact antistatique 20.

Le bracelet de protection 20 est connecté à un dispositif de protection 30, via un premier câble de connexion 32, comportant par exemple une fiche de connexion (non représentée sur la figure) adaptée à être insérée dans une prise aménagée dans un boîtier externe du dispositif de protection 30.

Lorsque l'opérateur est assis à son poste de travail, la principale protection contre les décharges électrostatiques est réalisée par le système de protection 2 comportant le bracelet de protection 20 relié à la peau de l'opérateur et le dispositif de protection 30.

Le dispositif de protection 30 est également relié à la terre par un deuxième câble 34, via une impédance de l'ordre de 1 à 2 MOhms.

De plus, le dispositif de protection 30 est connecté, via un troisième câble de connexion 36, au module de connexion 16.

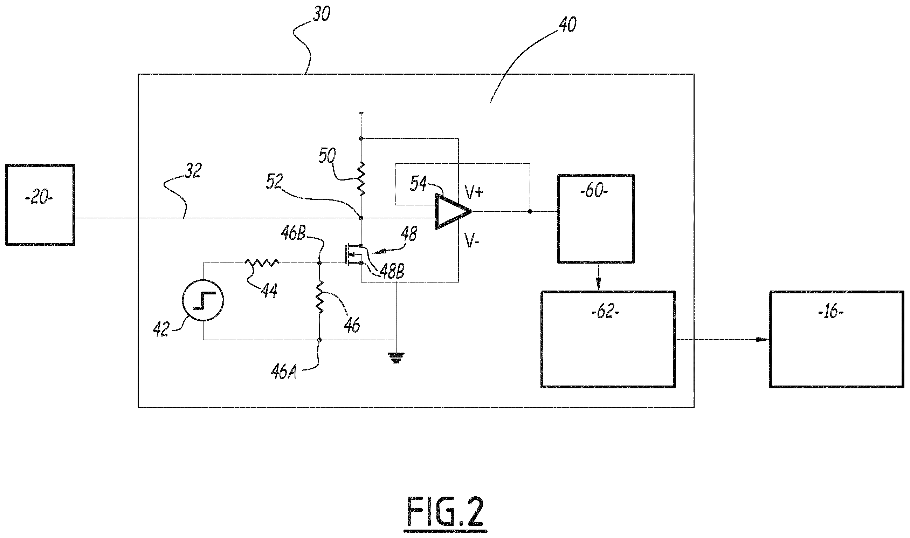

Le dispositif de protection 30 est configuré pour vérifier la présence d'un contact entre le bracelet de protection 20, et plus généralement le dispositif de contact 20, et la peau de l'opérateur. Un mode de réalisation de cette vérification sera décrit ci-après en référence à la figure 2.

En effet, il est important que le bracelet de protection 20 soit en contact avec la peau de l'opérateur, toute défaillance à ce contact créant une potentielle brèche de sécurité du système de protection.

En cas vérification positive, le dispositif de protection 30 commande l'alimentation électrique de la pluralité des équipements du poste de travail par le module de connexion 16.

En cas de vérification négative, le dispositif de protection 30 commande la coupure de l'alimentation électrique de la pluralité des équipements du poste de travail par le module de connexion 16.

Avantageusement, le dispositif de protection 30 permet de vérifier que le bracelet de protection 20, et plus généralement le dispositif de contact antistatique prévu, est porté en contact avec la peau de l'opérateur, et non en contact avec une surface autre qui présenterait des propriétés de résistance électrique équivalentes aux propriétés de résistance électrique de la peau humaine.

Avantageusement, le dispositif de protection 30 réalise une fonction d'interrupteur général des équipements du poste de travail 4. Cela permet, d'une part, d'améliorer la protection contre les décharges électrostatiques. D'autre part, cela représente un gain en temps et en confort de travail, puisque l'opérateur n'a pas besoin d'actionner manuellement un ou plusieurs interrupteurs d'alimentation électrique. De plus, le poste de travail n'est alimenté que lorsque l'opérateur est présent et correctement équipé du bracelet de protection, ce qui permet d'éviter d'alimenter en électricité un poste de travail en l'absence d'un opérateur.

La figure 2 représente un mode de réalisation d'un circuit 40, faisant partie d'un dispositif de protection 30, réalisant la vérification de présence d'un contact entre le bracelet de protection 20, et plus généralement du dispositif de contact prévu, et la peau de l'opérateur. Le circuit 40 sera plus simplement appelé circuit de vérification de contact par la suite.

Le circuit de vérification de contact 40 met en œuvre une vérification de résistance et une vérification de capacité électrique caractéristiques du corps humain.

Avantageusement, la vérification conjointe de la résistance et de la capacité permet d'augmenter la fiabilité de la vérification de contact.

Le circuit de vérification de contact 40 comporte une source de tension 42 en créneau, par exemple de fréquence 30Hz et de tension 5 Volts. Bien entendu, d'autres valeurs de fréquence et de tension peuvent être utilisées. Dans le circuit de vérification de contact 40, la source de tension 42 alimente avec une faible tension le bracelet de protection 20, afin d'estimer la résistance et la capacité dans le circuit, ce qui permet de vérifier la présence d'un contact entre le bracelet et la peau de l'opérateur. En effet, la peau soumise à une faible tension électrique a des caractéristiques de résistance et de capacité connues, modélisables par un circuit RC série avec une résistance de l'ordre d'une centaine de kilo ohms et une capacité de l'ordre d'une centaine de pico Farads. Une première résistance 44 est branchée en série avec la source de tension 42, et une deuxième résistance est branchée en parallèle.

Ces résistances sont utiles notamment pour polariser le transistor de la source de tension 42, afin de garantir le bon fonctionnement de ce composant.

Une première borne 46A de la deuxième résistance 46 est reliée à la terre.

Une deuxième borne 46B de la deuxième résistance 46 est connectée à une porte d'un transistor 48, par exemple un transistor à effet de champ de type MOSFET adapté pour de faibles courants.

Le drain 48B du transistor 48 est connecté à une troisième résistance 50, par exemple de 1 MOhms, via un point de connexion 52. Le câble de connexion 32 du bracelet de protection 20 est également connecté au point de connexion 52. La tension au point 52 est fournie en entrée d'un comparateur 54, qui améliore la précision de la mesure analogique.

La sortie du comparateur 54 est fournie à un dispositif de mesure 60.

Le dispositif de mesure 60 est adapté à mesurer la tension sur plusieurs intervalles de mesure, ce qui permet d'estimer la résistance et la capacité dans le circuit.

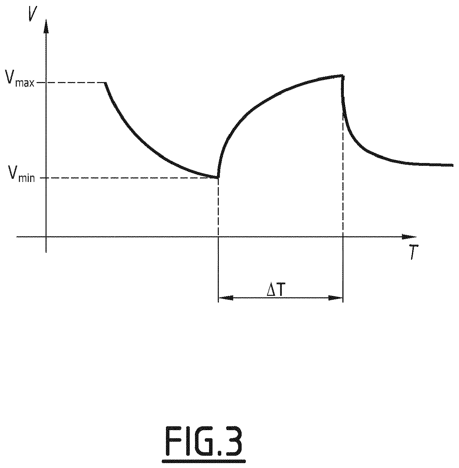

La figure 3 illustre schématiquement l'évolution de la tension mesurée en fonction du temps.

La différence de potentiel entre le potentiel maximum $V_{max}$ et le potentiel minimum $V_{min}$ permet d'estimer la résistance R de la peau de l'opérateur.

La durée $\Delta T$, mesurée sur le front montant comme illustré à la figure 3, permet d'estimer la capacité correspondant à la peau de l'opérateur par la formule :

$$C = \frac{\Delta T}{R}$$

Dans un mode de réalisation, les mesures de tension sont transmises à un module de calcul électronique 62, par exemple un microcontrôleur, qui effectue des calculs pour mettre en œuvre un procédé de protection contre des décharges électrostatiques.

Dans un mode de réalisation, le procédé est mis en œuvre par un logiciel contenant des instructions de code de programme, qui sont exécutables par le microcontrôleur 62.

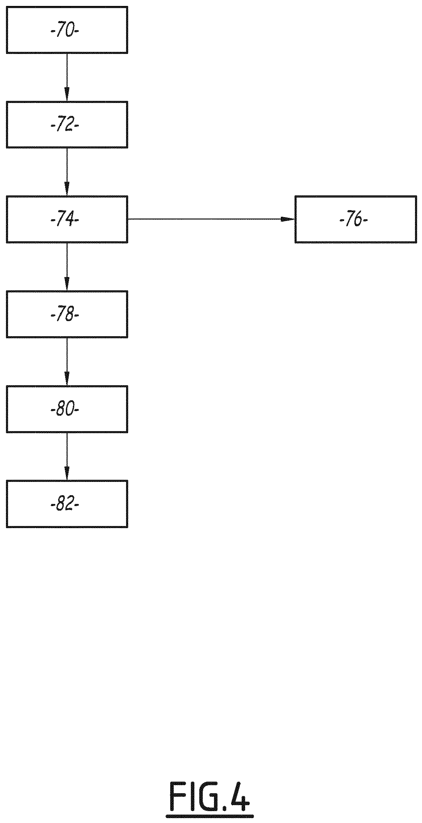

Le procédé, décrit en référence à la figure 4 dans un mode de réalisation, comporte une estimation 70 d'une valeur de résistance à partir des valeurs de tension mesurées, et une estimation 72 d'une valeur de capacité en appliquant la formule décrite ci-dessus. Les valeurs de résistance et de capacité estimées sont ensuite comparées à des seuils prédéterminés.

Par exemple, le microcontrôleur 62 met en œuvre une étape 74 de vérification de présence d'un contact. Le microcontrôleur 62 vérifie à l'étape 74, lors d'une première vérification, que la valeur de résistance R estimée est comprise entre une première valeur de résistance minimale $R_{min}$ et une deuxième valeur de résistance maximale $R_{max}$. Ces valeurs $R_{min}$ et $R_{max}$ sont préalablement enregistrées.

Dans un mode de réalisation, les valeurs $R_{min}$ et $R_{max}$ sont préalablement calculées, dans une phase de calibrage, pour un ou plusieurs opérateurs connus associés au poste de travail.

Selon une variante, les valeurs $R_{min}$ et $R_{max}$ sont des valeurs moyennes obtenues pour des opérateurs humains.

De plus, le microcontrôleur vérifie également à l'étape 74, lors d'une deuxième vérification, que la valeur de capacité C estimée est comprise entre une première valeur de capacité minimale $C_{min}$ et une deuxième valeur de capacité $C_{max}$. Ces valeurs $C_{min}$ et $C_{max}$ sont préalablement enregistrées.

Dans un mode de réalisation, les valeurs de capacité $C_{min}$ et $C_{max}$ sont préalablement calculées, dans une phase de calibrage, pour un ou plusieurs opérateurs connus associés au poste de travail.

Selon une variante, les valeurs $C_{min}$ et $C_{max}$ sont des valeurs moyennes obtenues pour des opérateurs humains.

Si à la fois la valeur de résistance et la valeur de capacité estimées sont comprises dans les plages attendues, alors la vérification de contact avec la peau de l'opérateur est positive, et le microcontrôleur envoie (étape 76) un signal de commande d'allumage de l'alimentation électrique du poste de travail.

Si l'une des valeurs de résistance ou de capacité estimées sort de la plage attendue, alors la vérification de contact avec la peau de l'opérateur est négative, et le microcontrôleur envoie (étape 78) un signal de commande de coupure de l'alimentation électrique du poste de travail.

Ainsi, avantageusement, à la fois la résistance et la capacité estimées sont prises en considération pour déclencher ou non l'alimentation électrique du poste de travail, ce qui permet d'augmenter la sécurité de l'opérateur.

Selon un mode de réalisation, les valeurs de résistance et de capacité estimées sont mémorisées à l'étape de mémorisation 80 dans une mémoire du microcontrôleur, ainsi que les résultats des vérifications de présence de contact, par exemple en association avec un instant ou avec un intervalle temporel de mesure. Cela permet en particulier de détecter, par exemple en comptant le nombre de vérifications négatives et de coupures de l'alimentation électrique du poste de travail, d'éventuels défauts dans le matériel utilisé.

Un rapport listant les données mémorisées à l'étape de mémorisation 80, ainsi que par exemple le nombre de coupures électriques, est généré à l'étape 82. Ainsi, il est possible de tracer de manière sécurisée les conditions de fabrication d'un composant électronique.

Avantageusement, le système de protection décrit permet d'augmenter la sécurité contre les décharges électrostatiques, d'augmenter l'ergonomie des postes de travail pour un opérateur et de mieux gérer la consommation d'électricité.

Avantageusement, le système de protection décrit est compatible avec tout dispositif de contact avec la peau assurant une protection antistatique.

## Revendications

1. Système de protection contre des décharges électrostatiques, comportant un dispositif de protection (30) adapté à être connecté à un dispositif de contact (20) antistatique assurant une protection contre des décharges électrostatiques lorsqu'il est porté par un opérateur (6) d'un poste de travail (4) comportant une pluralité d'équipements (8, 10) adaptés à fonctionner lorsqu'ils sont alimentés en électricité, **caractérisé en ce que** ledit dispositif de protection (30) est connecté entre le dispositif de contact (20) antistatique et un module de connexion électrique (16) du poste de travail,
ledit dispositif de protection (30) est configuré pour vérifier la présence d'un contact entre dispositif de contact (20) antistatique assurant une protection contre les décharges électrostatiques et la peau d'un opérateur (6),
et en cas vérification positive, le dispositif de protection (30) commande le module de connexion électrique (16) pour fournir une alimentation électrique à tous les équipements du poste de travail, et en cas de vérification négative, le dispositif de protection (30) commande une coupure de l'alimentation électrique des équipements du poste de travail.

2. Système de protection selon la revendication 1, dans lequel, pour la vérification de présence d'un contact entre ledit dispositif de contact (20) antistatique et la peau d'un opérateur, le dispositif de protection (30) met en œuvre une vérification de résistance et une vérification de capacité.

**3.** Système de protection selon la revendication 2, dans lequel ledit dispositif de protection (30) comprend un circuit (40) de vérification de présence d'un contact, comportant un comparateur (54), une sortie du dispositif de contact (20) antistatique étant connectée à une entrée dudit comparateur.

**4.** Système de protection selon la revendication 3, dans lequel ledit circuit (40) de vérification de présence d'un contact comprend une source de tension (42) alimentant, avec une tension inférieure ou égale à 10 Volts, le dispositif de contact (20) antistatique.

**5.** Système selon l'une des revendications 2 à 4, dans lequel ledit dispositif de protection (30) comporte en outre un module de calcul électronique (62) configuré pour calculer une valeur de résistance estimée et une valeur de capacité estimée.

**6.** Système selon la revendication 5, dans lequel ledit module de calcul électronique (62) est configuré pour vérifier, lors d'une première vérification, si la valeur de résistance estimée appartient à une plage de valeurs de résistance prédéterminée, et pour vérifier, lors d'une deuxième vérification, si la valeur de capacité estimée appartient à une plage de valeurs de capacité prédéterminée.

**7.** Système selon la revendication 6, dans lequel ladite plage de valeurs de résistance est définie par une première valeur de résistance minimale et une deuxième valeur de résistance maximale, préalablement calculées dans une phase de calibrage et enregistrées.

**8.** Système selon la revendication 6 ou la revendication 7, dans lequel ladite plage de valeurs de capacité est définie par une première valeur de capacité minimale et une deuxième valeur de capacité maximale, préalablement calculées dans une phase de calibrage et enregistrées.

**9.** Système selon l'une des revendications 6 à 8, dans lequel la vérification de présence d'un contact entre le dispositif de contact antistatique assurant une protection contre les décharges électrostatiques et la peau d'un opérateur est positive si ladite première vérification est positive et ladite deuxième vérification est positive.

**10.** Système selon la revendication 6, dans lequel la vérification de présence d'un contact entre le dispositif de contact (20) antistatique assurant une protection contre les décharges électrostatiques et la peau d'un opérateur est négative si l'une au moins desdites première vérification et deuxième vérification est négative.

**11.** Procédé de protection contre des décharges électrostatiques, mis en œuvre par un module de calcul électronique d'un dispositif de protection faisant partie d'un système de protection selon l'une quelconque des revendications 1 à 10, **caractérisé en ce qu'**il comprend des étapes de :

 - vérification (74) de présence d'un contact entre un dispositif de contact (20) antistatique assurant une protection contre les décharges électrostatiques et la peau d'un opérateur (6),

et en cas vérification positive, commande (76) de fourniture d'alimentation électrique à tous les équipements du poste de travail, et en cas de vérification négative, commande (78) de coupure de l'alimentation électrique des équipements du poste de travail.

**12.** Procédé selon la revendication 11, dans lequel la vérification (74) de présence d'un contact comporte :

 - une estimation (70, 72) de valeur de résistance et de valeur de capacité à partir de valeurs de tension mesurées sur des intervalles de mesure,
 - une première vérification (74) consistant à vérifier si la valeur de résistance estimée appartient à une plage de valeurs de résistance prédéterminée, et
 - une deuxième vérification (74) consistant à vérifier si la valeur de capacité estimée appartient à une plage de valeurs de capacité prédéterminée,

ladite vérification de présence étant positive si la première vérification et la deuxième vérification sont positives.

**13.** Procédé selon la revendication 12, comportant en outre une mémorisation (80) des valeurs de résistance et de capacité estimées et du résultat de la vérification de présence associé.

FIG.1

EP 3 817 515 A1

FIG.2

FIG.3

## FIG.4

Europäisches
Patentamt

European
Patent Office

Office européen
des brevets

# RAPPORT DE RECHERCHE EUROPEENNE

Numéro de la demande

EP 20 20 4992

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 4 649 374 A (HOIGAARD JAN C [US]) 10 mars 1987 (1987-03-10) * colonne 4, ligne 8 - colonne 7, ligne 33; figures 1-3 * ----- | 1-13 | INV. H05F3/02 H05F3/04 G01R31/52 G01R27/02 G01R31/28 G01R31/54 |
| A | EP 0 407 186 A2 (MINNESOTA MINING & MFG [US]) 9 janvier 1991 (1991-01-09) * colonne 4, ligne 44 - colonne 10, ligne 16; figures 1-3 * ----- | 1-13 | |
| A | US 5 686 897 A (LOH MEOW YEW PHILIP [US]) 11 novembre 1997 (1997-11-11) * colonne 3, ligne 41 - colonne 6, ligne 63; figures 1-4 * ----- | 1-13 | |

DOMAINES TECHNIQUES
RECHERCHES (IPC)

H05F
G01R
G08B

Le présent rapport a été établi pour toutes les revendications

| Lieu de la recherche | Date d'achèvement de la recherche | Examinateur |
|---|---|---|
| Munich | 26 février 2021 | Ernst, Uwe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 20 20 4992

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-02-2021

| Document brevet cité au rapport de recherche | | Date de publication | Membre(s) de la famille de brevet(s) | | Date de publication |
|---|---|---|---|---|---|
| US 4649374 | A | 10-03-1987 | AUCUN | | |
| EP 0407186 | A2 | 09-01-1991 | AT | 116446 T | 15-01-1995 |
| | | | CA | 2017630 A1 | 06-01-1991 |
| | | | DE | 69015474 T2 | 29-06-1995 |
| | | | EP | 0407186 A2 | 09-01-1991 |
| | | | HK | 190696 A | 25-10-1996 |
| | | | JP | H0368875 A | 25-03-1991 |
| | | | US | 5057965 A | 15-10-1991 |
| US 5686897 | A | 11-11-1997 | AUCUN | | |

EPO FORM P0460

Pour tout renseignement concernant cette annexe : voir Journal Officiel de l'Office européen des brevets, No.12/82